# EUROPEAN PATENT APPLICATION

(11) **EP 2 787 792 A1**
(43) Date of publication of application: **08.10.2014**
(21) Application number: 11876688.0
(22) Date of filing: 28.11.2011
(51) Int. Cl.: H05B 33/14

(54) **POLYMERIC ELECTROLUMINESCENT DEVICE AND METHOD FOR PREPARING SAME**

(71) Applicant: Ocean's King Lighting Science&Technology Co., Ltd., Guangdong 518054 (CN); Shenzhen Ocean's King Lighting Engineering Co. Ltd., Guangdong 518100 (CN)
(72) Inventor: ZHOU, Mingjie, Shenzhen Guangdong 518054 (CN); WANG, Ping, Shenzhen Guangdong 518054 (CN); HUANG, Hui, Shenzhen Guangdong 518054 (CN); CHEN, Jixing, Shenzhen Guangdong 518054 (CN)
(74) Representative: Michalski, Stefan
(86) International application number: PCT/CN2011/083031
(87) International publication number: WO 2013/078585

(57) **Abstract**

Disclosed are a polymeric electroluminescent device and a method for preparing the same. The polymeric electroluminescent device includes an anode (20), a hole injecting layer (30), a hole transportation layer (40), a light-emitting layer (50), a hole barrier layer (60), an electron transportation layer (70), an electron injecting layer (80) and a cathode (90) laminated in succession, and the material for the hole barrier layer (60) is zinc oxide, magnesium oxide, zinc sulphide or cadmium sulphide. In the polymeric electroluminescent device, zinc oxide, magnesium oxide, zinc sulphide or cadmium sulphide has a large particle size, and can scatter the light to improve extraction efficiency; at the same time, zinc oxide, magnesium oxide, zinc sulphide or cadmium sulphide has a high work function, which can excellently prevent transition of the holes and increase the recombination possibility of excitons, thereby improving the light-emitting efficiency of the polymeric electroluminescent device.

## Description

### FIELD OF THE INVENTION

The present invention relates to a polymer electroluminescent device and a method of preparing the polymer electroluminescent device.

### BACKGROUND OF THE INVENTION

Organic Light Emission Diode or Polymer Electroluminescent device, which are short for OLED, have characteristics of high brightness, wide range of material selection, low driving voltage, all-solid, and self-luminous, such characteristics conform to a development trend of mobile communication and information display in information age and a requirement of green lighting technology. The OLED is a very popular research subject in recent decades.

In polymer electroluminescent devices, an organic material with high HOMO energy level is usually used as a hole barrier layer. A transporting path of a hole is anode-hole transportation layer-light-emitting layer, a transporting path of an electron is cathode-electron transportation layer-light-emitting layer. When holes and electrons reach the light-emitting layer and recombine, excitons will be formed, which would lead to light emission. If a HOMO energy level between the light-emitting layer and the electron transportation layer is low, the holes will pass through the light-emitting layer to the electron transportation layer, thus the holes and electrons cannot be effectively recombined, a light emitting efficiency will be low, the general way to block holes is to evaporate a layer of organic material with high HOMO energy level (about -6.5eV) between the light-emitting layer and the electron transportation layer, a layer of organic material is used to block holes, and to restrict the holes in the light-emitting layer. However, a HOMO energy level of the light-emitting layer is usually in the range of from 6.2eV to 6.5 eV, and a HOMO potential barrier between the hole barrier layer and the light-emitting layer need to be reached about 0.5eV, in order to get an effective blocking, a HOMO energy level of the usual organic material is in the range of from 6.0eV to 6.5eV, such a HOMO energy level cannot get a good hole blocking effect, thus a light emitting efficiency of the polymer electroluminescent device is low.

### SUMMARY OF THE INVENTION

Accordingly to this, it is necessary to provide a polymer electroluminescent device with high light emitting efficiency and a method of preparing the polymer electroluminescent device.

A polymer electroluminescent device includes an anode, a hole injecting layer, a hole transportation layer, an light-emitting layer, a hole barrier layer, an electron transportation layer, an electron injecting layer, and a cathode, the hole barrier layer is made of a material selected from a group consisting of zinc oxide, magnesium oxide, zinc sulfide, or cadmium sulfide.

In one embodiment, a thickness of the hole barrier layer is in the range of from 1nm to 10nm.

In one embodiment, the anode is made of a material selected from a group consisting of indium tin oxide glass, fluorine-doped tin oxide glass, Al-doped zinc oxide glass, and indium-doped zinc oxide glass.

In one embodiment, the light-emitting layer is made of an light emitting material, or a mixture formed by an light emitting material and a host material, the light emitting material is selected from a group consisting of 4 - (methyl nitrile) -2 - butyl-6 - (1,1,7,7 - tetramethyl-9 it Gyula - vinyl)-4H-pyran, 8 - hydroxyquinoline aluminum, bis (4,6 - difluorophenyl pyridine-N, C²) iridium pyridine carboxamide, bis (2 - methyl - diphenyl [f, h] quinoxaline) (acetylacetonate) iridium, and tris (2 - phenylpyridine) iridium, the host material is at least one selected from a group consisting of 1,1 - [4 - [N, N'-two (p-tolyl) amino] phenyl] cyclohexane, N, N'-bis (3 - methylphenyl) - N, N'-diphenyl-4, 4'- biphenyl diamine, 2 - (4 - biphenylyl) -5 - (4 - tert-butyl) phenyl -1,3,4 - oxadiazole, 8 - hydroxyquinoline aluminum, 4,7 - diphenyl-1, 10 - phenanthroline, 1,2,4 - triazole derivatives and N-arylbenzimidazole, a mass content of the light emitting material in a mixture formed by the light emitting material and the host material is in the range of from 1% to 20%.

In one embodiment, the hole injecting layer is made of a material selected from a group consisting of molybdenum trioxide, tungsten trioxide, and vanadium pentoxide.

In one embodiment, the hole transportation layer is made of a material selected from a group consisting of 1,1 - [4 - [N, N'-two (p-tolyl) amino] phenyl] cyclohexane, N, N'-bis (3 - methylphenyl) - N, N'-diphenyl-4, 4'- biphenyl diamine, 4,4 ', 4" - tris (carbazol-9 - yl) triphenylamine and N, N'-(1 - naphthyl) - N, N'-diphenyl-4, 4'- biphenyl diamine.

In one embodiment, the electron transportation layer is made of a material selected from a group consisting of 2 - (4 - biphenylyl) -5 - (4 - tert-butyl) phenyl, 3,4 - oxadiazole, 8 - hydroxyquinoline aluminum, 4,7 - diphenyl-1, 10 - phenanthroline, 1,2,4 - triazole derivatives, and N-arylbenzimidazole.

In one embodiment, the electron injecting layer is made of electron injecting material or a mixture formed by of electron injecting material and electron transporting material, the electron injecting material is selected from a group consisting of cesium carbonate, lithium fluoride, and cesium azide, the electron transporting material is selected from a group consisting of 2 - (4 - biphenylyl) -5 - (4 - tert-butyl) phenyl -1,3,4 - oxadiazole, 8 - hydroxyquinoline aluminum, 4,7 - diphenyl-1, 10 - phenanthroline, 1,2,4 - triazole derivative, and N-aryl benzimidazole, a mass content of the electron injecting material in a mixture formed by electron injecting material and electron transporting material is in the range of from 20% to 60%.

In one embodiment, the cathode is made of a material selected from a group consisting of silver, aluminum, platinum, gold, and magnesium-silver alloy.

A method of preparing a polymer electroluminescent device, comprising:
providing an anode;
forming a hole injecting layer, a hole transportation layer, and an light-emitting layer sequentially on a surface of the anode;
forming a hole barrier layer on a surface of the light-emitting layer, the hole barrier layer is made of a material selected from a group consisting of zinc oxide, magnesium oxide, zinc sulfide, and cadmium sulfide; and forming an electron transportation layer, an electron injecting layer and a cathode sequentially on a surface of the hole barrier layer.

The above electroluminescent device uses zinc oxide, magnesium oxide, cadmium sulfide, or zinc sulfide as materials of the hole barrier layer, work functions of zinc oxide, magnesium oxide, zinc sulfide, and cadmium sulfide are as high as about -7.2 eV, which can block a transition of the holes, thus the holes are restricted in the light emitting layer to recombine with the electrons, which increases the probability of exciton recombination, thus the light emitting efficiency of the polymer electroluminescent device can be increased.

### BRIEF DESCRIPTION OF THE DRAWINGS

FIG. 1 is a schematic view of a polymer electroluminescent device according to one embodiment;
FIG. 2 is a flow chart of a method of preparing a polymer electroluminescent device according to one embodiment;
FIG. 3 is a graph illustrating a relationship between an electric current density and an electric current efficiency of a polymer electroluminescent device prepared according to Example 1 and Comparative Example 1.

### DETAILED DESCRIPTION OF THE EMBODIMENTS

A fully description of polymer electroluminescent device and its preparing method will be illustrated by reference to specific embodiments and drawings.

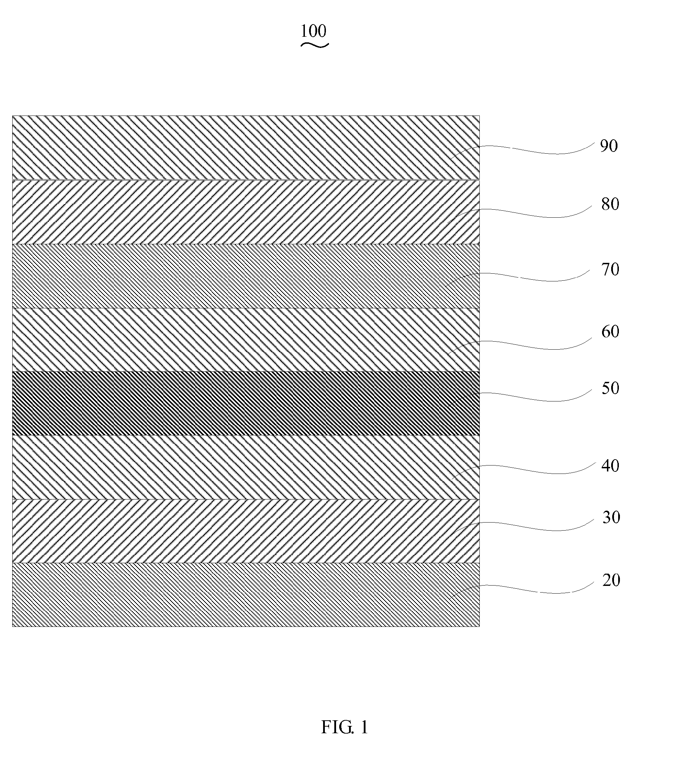

Referring to FIG. 1, an embodiment of a polymer electroluminescent device 100 includes an anode 20, a hole injecting layer 30, a hole transportation layer 40, an light-emitting layer 50, a hole barrier layer 60, an electron transportation layer 70, an electron injecting layer 80, and a cathode 90, which are laminated sequentially.

The anode 20 is made of a material selected from group consisting of indium tin oxide glass (ITO), fluorine-doped tin oxide glass (FTO), aluminum-doped zinc oxide glass (AZO), and indium-doped zinc oxide glass (IZO).

The hole injecting layer 30 is formed on a surface of the anode 20. The hole injecting layer is made of a material selected from a group consisting of molybdenum trioxide (MoO₃), tungsten trioxide (WO₃), and vanadium pentoxide (V₂O₅), preferably, the hole injecting layer 30 is made of MoO₃. A thickness of the hole injecting layer 30 is in the range of from 20 nm to 80 nm, preferably, the thickness of the hole injecting layer is 40 nm.

The hole transportation layer 40 is formed in a surface of the hole injecting layer. The hole transportation layer 40 is made of a material selected from a group consisting of 1,1 - [4 - [N, N'-two (p-tolyl) amino] phenyl] cyclohexane (TAPC), N, N'-bis (3 - methylphenyl) - N, N'-diphenyl-4, 4'- biphenyl diamine (TPD), 4,4 ', 4" - tris (carbazol-9 - yl) triphenylamine (TCTA), and N, N'-(1 - naphthyl) - N, N'-diphenyl-4, 4'- biphenyl diamine (NPB), preferably, the hole transportation layer is made of NPB. A thickness of the hole transportation layer 40 is in the range of from 20nm to 60 nm, preferably, the thickness of the hole transportation layer is 40 nm.

The light-emitting layer 50 is formed on a surface of the hole transportation layer 40. The light-emitting layer 50 is made of a light emitting material or a mixture formed by doping a light emitting material into a host material. The light emitting material is at least one selected from a group consisting of 4 - (dicyanomethylene) -2 - tert - butyl - 6 - (1,1,7,7 - tetramethyljulolidin -4- yl - vinyl) - 4h -pyran (DCJTB), 8 - hydroxyquinoline aluminum (Alq₃), Bis (4,6 - difluorophenyl pyridine-N, C²) iridium pyridine carboxamide (FIrpic), Bis (2 - methyl - diphenyl [f, h] quinoxaline) (acetylacetonate) iridium (Ir (MDQ)₂ (acac)), and Tris (2 - phenylpyridine) iridium (Ir(ppy)₃). The host material is at least one selected from a group consisting of 1,1 - [4 - [N, N'-two (p-tolyl) amino] phenyl] cyclohexane (TAPC), N, N'-bis (3 - methylphenyl) - N, 4,4 ', 4" - tris (carbazol-9 - yl) triphenylamine (TCTA), N, N'-(1 - naphthyl) - N, N'-diphenyl-4, 4'- biphenyl diamine (NPB), 2 - (4 - biphenylyl) -5 - (4 - tert-butyl) phenyl -1,3,4 - oxadiazole (PBD), 8 - hydroxyquinoline aluminum (Alq₃), 4,7 - dipheny-1, 10 - phenanthroline (Bphen), 1,2,4 - triazole derivatives (e.g., TAZ), and N-arylbenzimidazole (TPBI). A mass content of the light emitting material in a mixture formed by doping the light emitting material into the host material is in the range of from 1% to 20%. The light-emitting layer 50 is preferably made of Alq₃. A thickness of the light-emitting layer is in the range of from 2nm to 50 nm, preferably, the thickness is 30nm.

The hole barrier layer 60 is formed on a surface of the light-emitting layer. The hole barrier layer is made of a material selected from a group consisting of zinc oxide (ZnO), magnesium oxide (MgO), zinc sulfide (ZnS), and cadmium sulfide (CdS). A thickness of the hole barrier layer 60 is in the range of from 1nm to 10nm.

The electron transportation layer 70 is formed on a surface of the hole barrier layer 60. The electron transportation layer 70 is made of a material selected from a group consisting of 2 - (4 - biphenylyl) -5 - (4 - tert-butyl) phenyl -1,3,4 - oxadiazole (PBD), 8 - hydroxyquinoline aluminum (Alq₃), 4,7 - two phenyl-1, 10 - phenanthroline (Bphen), 1,2,4 - triazole derivatives (such as TAZ), and N-arylbenzimidazole (TPBI). Preferably, the electron transportation layer is made of Bphen. A thickness of the electron transportation layer is in the range of from 40nm to 80nm, preferably, the thickness is 60nm.

The electron injecting layer 80 is formed on a surface of the electron transportation layer 70. The electron injecting layer 80 is made of an electron injecting material or a mixture formed by doping the electron injecting material into the electron transporting material. The electron injecting material is made of a material selected from a group consisting of cesium carbonate (Cs₂CO₃), cesium azide (CsN₃), and lithium fluoride (LiF). The electron transporting material is made of a material selected from a group consisting of 2 - (4 - biphenylyl) -5 - (4 - tert-butyl) phenyl -1,3,4 - oxadiazole (PBD), 8 - hydroxyquinoline aluminum (Alq₃), 4,7 - two phenyl-1, 10 - phenanthroline (Bphen), 1,2,4 - triazole derivatives (such as TAZ), or N-arylbenzimidazole (TPBI). When only one electron injecting material is used, a thickness of the electron injecting layer is in the range of from 0.5mm to 10mm. When the mixture formed by doping the electron injecting material into the electron transporting material and having the electron injecting material with a mass content in a range of from 20% to 60% is used, the electron injecting layer 80 is preferably made of a mixture of Bphen: CsN₃, a ratio of CsN₃ to the mixture 20%, a thickness of the electron injecting layer is in the range of from 20nm to 60nm, preferably it is 40nm.

A cathode 90 is formed on a surface of the electron injecting layer 80. The cathode 90 is made of a material selected from a group consisting of silver(Ag), aluminum(Al), platinum(Pt), gold(Au), and magnesium-silver alloy, a mass ratio of magnesium to silver is 10:1 in magnesium-silver alloy. The cathode is preferably made of magnesium-silver alloy. A thickness of the cathode is in the range of from 80nm to 250nm, preferably, the thickness is 100nm.

In the above electroluminescent device 100, the hole barrier layer 60 is made of zinc oxide, magnesium oxide, zinc sulfide, or cadmium sulfide. As work functions of zinc oxide, magnesium oxide, zinc sulfide, and cadmium sulfide are as high as -7.2eV, a potential barrier of the hole into the hole barrier layer will increase greatly, the hole barrier layer can block holes from transition, which makes the holes recombine with the electrons in the light-emitting layer, which increases a recombination probability of excitons, thus an emitting efficiency of the electroluminescent device can be enhanced. Material of the hole barrier layer 60 is plenty, and price of the material is low, which helps to control a preparing cost of the electroluminescent device. Meanwhile, sizes of zinc oxide particle, magnesium oxide particle, zinc sulfide particle, or cadmium sulfide particle are large, which can effectively scatter light passed into the light-emitting layer 50, thus an emitting efficiency is further enhanced.

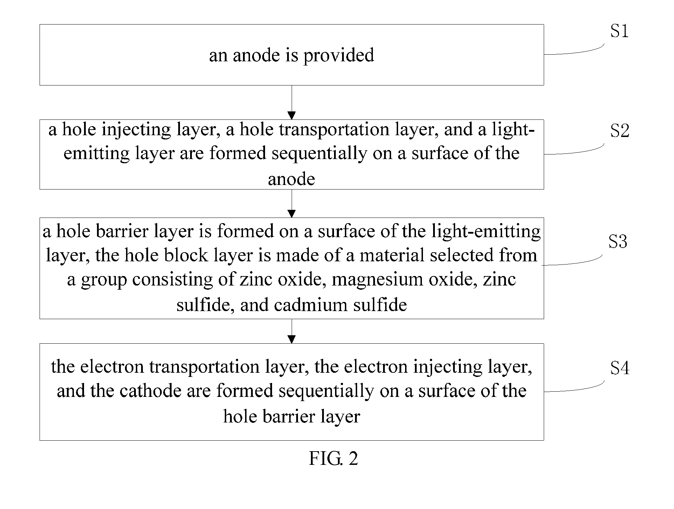

Referring to FIG. 2, an embodiment of a preparing method of the electroluminescent device includes:

Step S1, an anode 20 is provided.

In the illustrated embodiment, the anode 20 is made of a material selected from a group consisting of indium tin oxide glass (ITO), fluorine-doped tin oxide glass (FTO), aluminum-doped zinc oxide glass (AZO), and indium-doped zinc oxide glass (IZO).

In the illustrated embodiment, before use, the anode 20 is ultrasonically-treated with deionized water, acetone, ethanol, isopropanol for 15 minutes respectively to remove organic pollutions on a surface of the anode. The cleaned anode is plasma treated for 2 to 15 minutes with a power of 10W to 50W.preferably, the anode is plasma treated for 5 minutes at a power of 35 W

Step S2, a hole injecting layer, a hole transportation layer, and a light-emitting layer are formed sequentially on a surface of the anode.

The hole injecting layer 30 is formed on a surface of the anode. The hole injecting layer 30 is formed by vacuum thermal evaporation. The hole injecting layer is made of a material selected from a group consisting of molybdenum trioxide (MoO₃), tungsten trioxide (WO₃), and vanadium pentoxide (V₂O₅), preferably, it is made of MoO₃. A thickness of the hole injecting layer is in the range of from 20 nm to 80 nm, preferably, it is 40 nm. The hole transportation layer 40 is formed on a surface of the hole injecting layer 30.

The hole transportation layer 40 is formed by vacuum thermal evaporation. The hole transportation layer 40 is made of 1,1 - [4 - [N, N'-two (p-tolyl) amino] phenyl] cyclohexane (TAPC), N, N'-bis (3 - methylphenyl) - N, N'-diphenyl-4, 4'-biphenyl diamine (TPD), 4,4', 4" - tris (carbazol-9 - yl) triphenylamine (TCTA), or N, N'-(1 - naphthyl) - N, N'-diphenyl-4, 4'- biphenyl diamine (NPB), preferably, the hole transportation layer 40 is made of NPB. A thickness of the hole transportation layer is in the range of from 20nm to 60 nm, preferably, the thickness is 40nm.

In the illustrated embodiment, the light-emitting layer 50 is formed by vacuum thermal evaporation. The light-emitting layer 50 is made of a material selected from a group consisting of the light emitting material and the mixture formed by doping the light emitting material into the host material. The light emitting material is at least one selected from a group consisting of 4-(methyl nitrile)-2-butyl-6-(1,1,7,7- tetramethyl-9 it Gyula - vinyl)-4H-pyran (DCJTB), 8 - hydroxy-quinoline aluminum (Alq₃), bis (4,6 - difluorophenyl pyridine-N, C²) iridium pyridine carboxamide (FIrpic), bis (2-methyl-diphenyl [f, h] quinoxaline) (acetylacetonato) iridium (Ir (MDQ) 2 (acac)), and tris (2 - phenylpyridine) iridium (Ir (ppy)₃). The host material is one or two selected from a group consisting of 1,1 - [4 - [N, N'-two (p-tolyl) amino] phenyl] cyclohexane (TAPC), N, N'-bis (3 - methylphenyl) - N, N'-diphenyl-4, 4'- biphenyl diamine (TPD), 4,4 ', 4" - tris (carbazol-9 - yl) triphenylamine (TCTA), N, N'-(1 - naphthyl) - N, N'-diphenyl-4, 4'-biphenyl diamine (NPB), 2 - (4 - biphenylyl) -5 - (4 - tert-butyl) phenyl - 1,3,4 - oxadiazole (PBD), 8 - hydroxyquinoline aluminum (Alq₃), 4,7 - diphenyl-1, 10 - phenanthroline (Bphen), 1,2,4-triazole derivatives (e.g., TAZ), and N-aryl-benzimidazole (TPBI). A mass content of the light emitting material in the mixture formed by doping the light emitting material into the host material is in the range of from 1% to 20%. The light-emitting layer 50 is preferably made of Alq₃. A thickness of the light-emitting layer is in the range of from 2nm to 50nm, preferably, it is 30 nm.

Step S3, a hole barrier layer 60 is formed on a surface of the light-emitting layer, the hole barrier layer 60 is made of a material selected from a group consisting of zinc oxide, magnesium oxide, zinc sulfide, and cadmium sulfide.

In the illustrated embodiment, the hole barrier layer is prepared by electron beam, a thickness of the hole barrier layer 60 is in the range of from 1nm to 10 nm.

Step S4, the electron transportation layer 70, the electron injecting layer 80, and the cathode 90 are formed sequentially on a surface of the hole barrier layer 60.

The electron transportation layer 70 is formed on a surface of the hole barrier layer 60. The electron transportation layer 70 is formed by evaporation. The electron transportation layer 70 is made of a material selected from a group consisting of 2 - (4 - biphenylyl) -5 - (4 - tert-butyl) phenyl -1,3,4 - oxadiazole (PBD), 8 - hydroxyquinoline aluminum (Alq3), 4,7 - two phenyl-1, 10 - phenanthroline (Bphen), 1,2,4 - triazole derivatives (such as TAZ), and N-arylbenzimidazole (TPBI), preferably, it is made of Bphen.

A thickness of the electron transportation layer is in the range of from 40 nm to 80 nm, preferably, it is 60nm. The electron injecting layer 80 is formed on a surface of the electron transportation layer. The electron injecting layer 80 is formed by evaporation. The electron injecting layer 80 is made of electron injecting material or the mixture formed by doping the electron injecting material into the electron transportation layer. The electron injecting material is selected from a group consisting of cesium carbonate (Cs₂CO₃), cesium azide (CsN₃), and lithium fluoride (LiF). The electron transporting material is selected from a group consisting of 2 - (4 - biphenylyl) -5 - (4 - tert-butyl) phenyl -1,3,4 - oxadiazole (PBD), 8 - hydroxyquinoline aluminum (Alq3), 4,7 - two phenyl-1, 10 - phenanthroline (Bphen), 1,2,4 - triazole derivatives (such as TAZ), and N-arylbenzimidazole (TPBI). A mass content of the electron injecting material in the mixture formed by doping the electron injecting material into the electron transporting material is in the range of from 20% to 60%. The electron injecting layer 80 is preferably made of Bphen:CSN₃, a mass content of the CSN₃ is 20%. A thickness of the electron injecting layer 80 is in the range of from 20nm to 60nm, preferably, the thickness is 40nm.

In the illustrated embodiment, the cathode 90 is made of a material selected from group consisting of silver (Ag), aluminum (Al), platinum (Pt), gold (Au), and magnesium-silver alloy (Mg-Ag), a mass ratio of magnesium to silver in the magnesium-silver alloy is 10:1. The cathode 90 is made of magnesium-silver alloy. A thickness of the cathode is in the range of from 80nm to 250nm, preferably, it is 100nm.

The above preparing method of the electroluminescent device has simple process, the hole barrier layer is prepared by electron beam, a thickness of the hole barrier layer is easy to be controlled, and an obtained electroluminescent device according to the method has high light emitting efficiency.

The followings are specific embodiments.

Preparing and testing devices used in following examples and comparative example include: a high vacuum coating equipment (Shenyang Scientific Instrument Development Center limited company, pressure<1×10⁻³Pa), a current-voltage testing device (U.S. Keithly, model: 2602), an electroluminescent spectra testing device (U. S. photo research company, model: PR650), and screen luminance meter (Beijing Normal University, Model: ST-86LA).

### Example 1

A polymer electroluminescent device of the Example 1 has a structure of: ITO/ MoO₃/ NPB/ Alq₃/ ZnO/Bphen/ Bphen:CsN₃/ Mg-Ag.

A method of preparing the electroluminescent device according to Example 1 included:
The ITO was ultrasonically-treated using detergent, deionized water, acetone, ethanol, isopropanol for 15 minutes respectively to remove organic contaminants on a glass surface, then the ITO was treated by oxygen plasma. A hole injecting layer made of MoO₃ was formed by evaporation, a thickness of the hole injecting layer was 40nm. A hole transportation layer made of NPB was evaporated, a thickness of the hole transportation layer was 40nm. A light-emitting layer made of Alq₃ was evaporated, a thickness of the light-emitting layer was 30nm. A hole barrier layer made of ZnO was evaporated by an electron beam, a thickness of the hole barrier layer was 5 nm. An electron transportation layer made of Bphen was evaporated, a thickness of the electron transportation layer was 60 nm. An electron injecting layer made of Bphen: CsN₃ (a mass content of the CsN₃ is 20%) was evaporated, a thickness of the electron injecting layer is 40 nm. A cathode made of magnesium-silver alloy was then evaporated, a thickness of the cathode was 100 nm. Finally the electroluminescent device was obtained.

### Example 2

A polymer electroluminescent device of Example 2 included: IZO/ WO₃/ TAPC/ DCJTB/ ZnS/TAZ/ LiF/ Al.

A preparing process of the polymer electroluminescent device of the Example 2 included:
The IZO was ultrasonically-treated using detergent, deionized water, acetone, ethanol, isopropanol for 15 minutes respectively to remove organic contaminants on a glass surface. Then the IZO was treated by oxygen plasma. A hole injecting layer made of WO₃ was formed by evaporation, a thickness of the hole injecting layer was 80nm. A hole transportation layer made of TAPC was evaporated, a thickness of the hole transportation layer was 60nm. A light-emitting layer made of DCJTB was evaporated, a thickness of the light-emitting layer was 50nm. A hole barrier layer made of ZnS was evaporated by electron beam, a thickness of the hole barrier layer was 1 nm. An electron transportation layer made of TAZ was evaporated, a thickness of the electron transportation layer was 40 nm. An electron injecting layer made of LiF was evaporated, a thickness of the electron injecting layer was 0.5 nm. A cathode made of Al was then evaporated, a thickness of the cathode was 250 nm. Finally, the electroluminescent device was obtained.

### Example 3

A structure of the polymer electroluminescent device of example 3 included: AZO/ V₂O₅/ TCTA/ TCTA:Ir(MDQ)2(acac)/ CdS/TPBi/ LiF/ Au.

A preparing process of the electroluminescent device according to Example 3 included:
The AZO was ultrasonically-treated using detergent, deionized water, acetone, ethanol, isopropanol for 15 minutes respectively to remove organic contaminants on a glass surface. Then the AZO was treated by oxygen plasma. A hole injecting layer made of V₂O₅ was fabricated by evaporation, a thickness of the hole injecting layer was 20 nm. A hole transportation layer made of TCTA was evaporated, a thickness of the hole transportation layer was 20 nm. An light-emitting layer made of TCTA:Ir(MDQ)2(acac) (a doped mass content of the Ir(MDQ)2(acac) is 1%) was evaporated, a thickness of the light-emitting layer was 2nm. A hole barrier layer made of CdS was evaporated by electron beam, a thickness of the hole barrier layer was 5 nm. An electron transportation layer made of TPBi was evaporated, a thickness of the electron transportation layer was 80 nm. An electron injecting layer made of LiF was evaporated, a thickness of the electron injecting layer was 0.7 nm. A cathode made of Au was then evaporated, a thickness of the cathode was 80 nm. Finally, the electroluminescent device was obtained.

### Example 4

A structure of the polymer electroluminescent device according to Example 4 included: FTO/ WO₃/ TPD/ TCTA: Ir(ppy)₃/ MgO/PBD/ Cs₂CO₃/ Pt.

A preparing method of the electroluminescent device according to Example 4 included:
The FTO was ultrasonically-treated using detergent, deionized water, acetone, ethanol, isopropanol for 15 minutes respectively to remove organic contaminants on a glass surface. Then the AZO was treated by oxygen plasma. A hole injecting layer made of WO₃ was fabricated by evaporation, a thickness of the hole injecting layer was 30nm. A hole transportation layer made of TPD was evaporated, a thickness of the hole transportation layer was 30nm. An light-emitting layer made of TCTA: Ir(ppy)₃ (a mass content of the Ir(ppy)₃ is 10%) was evaporated, a thickness of the light-emitting layer was 10nm. A hole barrier layer made of MgO was evaporated by electron beam, a thickness of the hole barrier layer was 10 nm. An electron transportation layer made of PBD was evaporated, a thickness of the electron transportation layer was 30 nm. An electron injecting layer made of Cs₂CO₃ was evaporated, a thickness of the electron injecting layer was 5 nm. A cathode made of Pt was then evaporated, a thickness of the cathode was 150 nm. Finally, the electroluminescent device was fabricated according to the above processes.

### Example 5

A structure of the polymer electroluminescent device according to Example 5 included: ITO/ MoO₃/ TCTA/ TCTA: Firpic/ ZnS/Bphen/ CsN₃/ Ag.

A preparing process of the polymer electroluminescent device according to example 5 included:
The ITO was ultrasonically-treated using detergent, deionized water, acetone, ethanol, isopropanol for 15 minutes respectively to remove organic contaminants on a glass surface. Then the ITO was treated by oxygen plasma. A hole injecting layer made of MoO₃ was fabricated by evaporation, a thickness of the hole injecting layer was 50nm. A hole transportation layer made of TCTA was evaporated, a thickness of the hole transportation layer was 35nm. An light-emitting layer made of TCTA: Firpic (a mass content of the Firpic was 20%) was evaporated, a thickness of the light-emitting layer was 20nm. A hole barrier layer made of ZnS was evaporated by an electron beam, a thickness of the hole barrier layer was 4 nm. An electron transportation layer made of Bphen was evaporated, a thickness of the electron transportation layer was 40 nm. An electron injecting layer made of CsN₃ was evaporated, a thickness of the electron injecting layer was 2 nm. A cathode made of Ag was then evaporated, a thickness of the cathode was 200 nm. Finally, the electroluminescent device was obtained.

### Comparative example 1

In the comparative example 1, a polymer electroluminescent device prepared according to claim 1 included: ITO/ MoO₃/ NPB/ Alq₃/ Bphen/ CsN₃: Bphen/ Mg-Ag. The polymer electroluminescent device did not include a hole barrier layer. Material and thickness of other layers are the same as that of other layers of the polymer electroluminescent device.

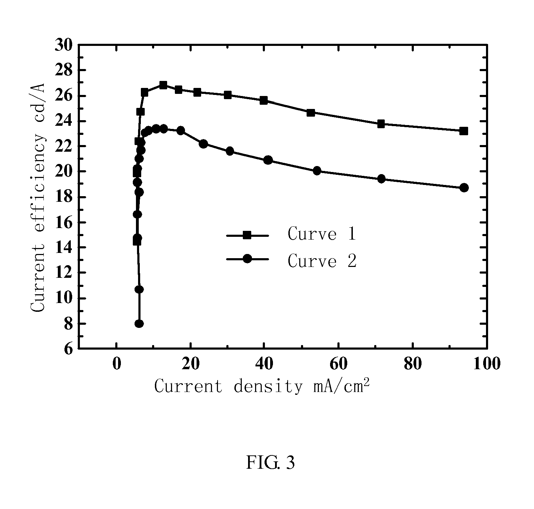

Referring to FIG. 3, curve 1 in FIG. 3 was a relation between current density and current efficiency of the polymer electroluminescent device prepared according to example 1. Curve 2 was a relationship between current density and current efficiency of the electroluminescent device prepared according to the comparative example 1. As it could be concluded from FIG. 3, a current efficiency in the example 1 was greater than in the comparative example 1, the greatest current efficiency in the example 1 was 26.8 cd/A, the greatest current efficiency in the comparative example was 23.3 d/A, which had proved that holes could be blocked when the hole barrier layer is made of inorganic metal oxide. Thus holes could be blocked, holes were recombined with electrons in the light-emitting layer, the recombination efficiency could be enhanced, and also the light emitting efficiency could be enhanced.

Although the present invention has been described with reference to the embodiments thereof and the best modes for carrying out the present invention, it is apparent to those skilled in the art that a variety of modifications and changes may be made without departing from the scope of the present invention, which is intended to be defined by the appended claims.

## Claims

1. A polymer electroluminescent device, comprising an anode, a hole injecting layer, a hole transportation layer, an light-emitting layer, a hole barrier layer, an electron transportation layer, an electron injecting layer, and a cathode, which are sequentially laminated, wherein the hole barrier layer is made of a material selected from a group consisting of zinc oxide, magnesium oxide, zinc sulfide, and cadmium sulfide.

2. The polymer electroluminescent device according to claim 1, wherein a thickness of the hole barrier layer is in the range of from 1nm to 10nm.

3. The polymer electroluminescent device according to claim 1, wherein the anode is made of a material selected from a group consisting of indium tin oxide glass, fluorine-doped tin oxide glass, Al-doped zinc oxide glass, and indium-doped zinc oxide glass.

4. The polymer electroluminescent device according to claim 1, wherein the light-emitting layer is made of a light emitting material, or a mixture formed by doping the light emitting material into a host material, the light emitting material is at least one selected from a group consisting of 4 - (dicyanomethylene) - 2 - tert - butyl - 6 - (1,1,7,7 - tetramethyljulolidin 4 - yl - vinyl) - 4h - pyran, 8 - hydroxyquinoline aluminum, bis(4, 6 - difluorophenyl pyridine-N, C²)iridium pyridine carboxamide, bis (2 - methyl - diphenyl [f, h] quinoxaline) (acetylacetonate) iridium, and tris(2-phenylpyridine) iridium, the host material is at least one selected from a group consisting of 1,1 - [4 - [N, N'-two (p-tolyl) amino] phenyl] cyclohexane, N, N'-bis (3 - methylphenyl) - N, N'-diphenyl-4, 4'- biphenyl diamine, 2 - (4 - biphenylyl) -5 - (4 - tert-butyl) phenyl -1,3,4 - oxadiazole, 8 - hydroxyquinoline aluminum, 4,7 - diphenyl-1, 10 - phenanthroline, 1,2,4 - triazole derivatives, and N-arylbenzimidazole, a mass content of the light emitting material in the mixture formed by doping the light emitting material into the host material is in a range of from 1% to 20%.

5. The polymer electroluminescent device according to claim 1, wherein the hole injecting layer is made of a material selected from a group consisting of molybdenum trioxide, tungsten trioxide, and vanadium pentoxide.

6. The polymer electroluminescent device according to claim 1, wherein the hole transportation layer is made of a material selected from a group consisting of 1,1 - [4 - [N, N'-two (p-tolyl) amino] phenyl] cyclohexane, N, N'-bis (3 - methylphenyl) - N, N'-diphenyl-4, 4'- biphenyl diamine, 4,4', 4" - tris (carbazol-9 - yl) triphenylamine, and N, N'-(1 - naphthyl) - N, N'-diphenyl-4, 4'- biphenyl diamine.

7. The polymer electroluminescent device according to claim 1, wherein the electron transportation layer is made of a material selected from a group consisting of 2 - (4 - biphenylyl) -5 - (4 - tert-butyl) phenyl, 3,4 - oxadiazole, 8 - hydroxyquinoline aluminum, 4,7 - diphenyl-1, 10 - phenanthroline, 1,2,4 - triazole derivatives, and N-arylbenzimidazole.

8. The polymer electroluminescent device according to claim 1, wherein the electron injecting layer is made of electron injecting material or a mixture formed by doping electron injecting material into electron transporting material, the electron injecting material is selected from a group consisting of cesium carbonate, lithium fluoride, and cesium azide; the electron transporting material is selected from a group consisting of 2 - (4 - biphenylyl) -5 - (4 - tert-butyl) phenyl -1,3,4 - oxadiazole, 8 - hydroxyquinoline aluminum, 4,7 - diphenyl-1, 10 - phenanthroline, 1,2,4 - triazole derivative, and N-aryl benzimidazole; a mass content of the electron injecting material in the mixture formed by doping electron injecting material into electron transporting material is in the range of from 20% to 60%.

9. The polymer electroluminescent device according to claim 1, wherein the cathode is made of a material selected from a group consisting of silver, aluminum, platinum, gold, and magnesium-silver alloy.

10. A method of preparing a polymer electroluminescent device, comprising the steps of:
providing an anode;
forming a hole injecting layer, a hole transportation layer, and an light-emitting layer sequentially on a surface of the anode;
forming a hole barrier layer on a surface of the light-emitting layer, wherein the hole barrier layer is made of a material selected from a group consisting of zinc oxide,
magnesium oxide, zinc sulfide, or cadmium sulfide; and
forming an electron transportation layer, an electron injecting layer, and a cathode sequentially on a surface of the hole barrier layer.
